# EUROPÄISCHE PATENTSCHRIFT

(11) **EP 0 330 957 B1**
(45) Veröffentlichungstag und Bekanntmachung des Hinweises auf die Patenterteilung: **15.06.1994**
(21) Anmeldenummer: 89102906.8
(22) Anmeldetag: 20.02.1989
(51) Int. Cl.: H05K 7/14

(54) **Frontsystem für in Baugruppenträger einschiebbare Steckbaugruppen eines mechanischen Aufbausystems**
Frontal system for mechanical assembly modules slidable in a supporting structure
Système frontal pour des modules d'un ensemble mécanique enfichables dans une structure support

(30) Priorität: 02.03.1988 DE 8802800 U
(43) Veröffentlichungstag der Anmeldung: 06.09.1989
(73) Patentinhaber: SIEMENS AKTIENGESELLSCHAFT, 80333 München (DE)
(72) Erfinder: Behrens, Ralf, Dipl.-Ing. (FH), D-8500 Nürnberg (DE); Schaffer, Kurt-Michael, D-8501 Eckental (DE); Schierreich, Helmut, D-8501 Veitsbronn (DE)

(56) Entgegenhaltungen:
- EP-A- 0 129 883
- DE-A- 3 407 877
- US-A- 4 233 646

## Beschreibung

Die Erfindung bezieht sich auf ein Frontsystem für eine in einen Baugruppenträger einschiebbare Steckbaugruppe (4) eines mechanischen Aufbausystemes, mit einer Steck- und Ziehhilfe (12), dessen mindestens einer Hebel (14) einen selbsthemmenden, federnden Rasthaken (24) aufweist und mittels eines Endstückes (16) derart mit der Steckbaugruppe (4) verbunden ist, daß die Drehachse (20) des Hebels (14) senkrecht zur Einschubebene in dem Endstück (16) gelagert ist, und mit einer Frontplatte (8), welche formschlüssig mit dem mindestens einen Endstück (16) verbunden ist, wobei
a) der Hebel (14) eine aus einer äußeren und inneren Nase (32, 34) bestehende Nut (30) aufweist, die in der Verriegelungsposition des Hebels (14) eine zur Nut (30) korrespondierende Nase (36) von einer Nut (37) in einer Querschiene (2) des Baugruppenträgers umgreift.

Ein derartiges Frontsystem ist aus der deutschen Offenlegungsschrift DE 33 22 856 A1 bekannt. Bei diesem Frontsystem wird mittels eines oberen und unteren Hebels beim Stecken und Ziehen einer Steckbaugruppe durch Krafteinwirkung am Hebel eine Hebelkraft bezüglich der Drehachse des Hebels ausgeübt, wodurch die Steckbaugruppe entweder gesteckt oder gezogen wird, wenn gleichzeitig auf die am Hebel angebrachte Blattfeder mit Rastnase eine Kraft einwirkt, die den Hebel entriegelt. Somit muß man Kräfte in zwei verschiedenen Richtungen für jede einzelne Steck-und Ziehhilfe aufbringen, um eine Steckbaugruppe in bzw. aus einem Baugruppenträger zu stecken bzw. zu ziehen. Dabei verlaufen die Kräfte für jede Steck- und Ziehhilfe zueinander entgegengesetzt pro Steckbaugruppe. Das nicht gleichzeitige Aufbringen von Kräften in zwei verschiedenen Wirkrichtungen an einer Steck- und Ziehhilfe kann zur Beschädigung der Steck- und Ziehhilfe führen.

Der Erfindung liegt nun die Aufgabe zugrunde, ein Frontsystem für in Baugruppenträger einschiebbare Steckbaugruppen zu schaffen, wobei sich der Kraftaufwand beim Stecken und Ziehen einer Steckbaugruppe vermindert und die ergonomische Handhabung sich verbessert.

Diese Aufgabe wird erfindungsgemäß dadurch gelöst, daß der Rasthaken (24) in der Verriegelungsposition des Hebels (14) eine über die Frontplatte (8) hinausstehende Nase (26) von einer der Querschiene (2) zugewandten Nut (28) des Endstückes (16) hintergreift.

Durch diese Gestaltung des Hebels und des Endstücks wird erreicht, daß zum Stecken bzw. Ziehen einer Steckbaugruppe in bzw. aus einem Baugruppenträger auf jede Steck- und Ziehhilfe der Steckbaugruppe eine Kraft einwirkt, die einander entgegengesetzt sind und parallel zur Frontseite des Frontsystems der Steckbaugruppe verlaufen. Außerdem bleibt die Steckbaugruppe auch bei hoher mechanischer Beanspruchung sicher im Steckverbinder stecken und am Frontsystem verriegelt. Somit vermindert sich der Kraftaufwand beim Stecken bzw. Ziehen einer Steckbaugruppe in bzw. aus einem Baugruppenträger, wobei die Handhabung ergonomischer geworden ist.

In einer vorteilhaften Ausführungsform des Frontsystems ist die innere Nase der Nut des Hebels derart mit einem Schlitz versehen, daß der der Nut des Hebels abgewandte Teil der inneren Nase einen federnden Schenkel bildet. Durch diese Gestaltung der inneren Nase der Nut des Hebels wird in der Verriegelungsposition des Hebels diese innere Nase der Nut des Hebels in der Nut der Querschiene des Baugruppenträgers verspannt, so daß die Verriegelung der Steckbaugruppe unterstützt wird, wodurch die Steckbaugruppe auch bei Schwingungsbeanspruchungen sicher im Steckverbinder gesteckt bleibt.

In einer weiteren vorteilhaften Ausführungsform des Frontsystems ist das Endstück mit einem senkrecht zur Einschubrichtung verlaufenden Schlitz versehen, wobei in beiden diesen Schlitz begrenzenden Wänden jeweils eine Gewindebohrung vorgesehen ist, die axial in Einschubrichtung angeordnet sind. Dadurch können Frontplatten aus U-Profil bzw. Flachmaterial unterschiedlicher Breite verwendet werden, ohne daß dabei die Breite der Steck- und Ziehhilfe an die Breite der Frontplatte angepaßt werden muß. Somit werden die Steck- und Ziehkräfte nur dort am Hebel aufgebracht, wo an der dem Frontsystem gegenüberliegenden, senkrechten Kante der Leiterplatte der Steckbaugruppe die hochpoligen Steckverbinder angeordnet sind, wodurch keine zusätzlichen Hebelkräfte auf die Frontplatte einwirken können. Durch die kraftschlüssige Verbindung der Frontplatte mit dem Endstück wird die elektrische Kontaktierung der Frontplatte zum Endstück erheblich verbessert.

In einer weiteren vorteilhaften Ausgestaltung des Frontsystems mit einer Frontplatte, deren Breite größer als die Breite einer Steck- und Ziehhilfe ist, ist eine verbleibende, vom Endstück nicht besetzte Restbreite der Frontplatte mit einer Abdeckung versehen, wobei die Abdeckung form- und/oder kraftschlüssig mit der Frontplatte verbunden ist. Durch diese Maßnahmen können Frontplatten verwendet werden, deren Restbreite sich rechts und links vom Endstück mit Hebel erstrecken können, und trotzdem der dieser Steckbaugruppe korrespondierende Teil der Querschiene abgedeckt werden.

In einer weiteren vorteilhaften Ausführungsform des Frontsystems sind Blindplatten, bestehend aus einer Frontplatte und zweier Abdeckungen, zur Überbrückung der Front von nicht mit Steckbaugruppen besetzten Teilen des Baugruppenträgers vorgesehen. Dadurch kann man jeden beliebigen nicht mit Steckbaugruppen besetzten Teil des Baugruppenträgers unabhängig von seiner Breite mit einer Blindplatte preiswert überbrücken.

Zur weiteren Erläuterung der Erfindung wird auf die Zeichnung Bezug genommen, in der mehrere Ausführungsbeispiele eines Frontsystems nach der Erfindung schematisch veranschaulicht sind.
- FIG 1: zeigt wesentliche Teile eines erfindungsgemäßen Frontsystems, in
- FIG 2: ist eine vorteilhafte Ausführung des Endstücks des Frontsystems veranschaulicht, in
- FIG 3: sind zwei Ausführungsformen des Frontsystems mit unterschiedlichen Frontplatten dargestellt, die
- FIG 4: zeigt eine weitere vorteilhafte Asuführungsform des Frontsystems mit Frontplatte und in
- FIG 5: ist eine Ausführungsform des Frontsystems mit Blindplatte dargestellt.

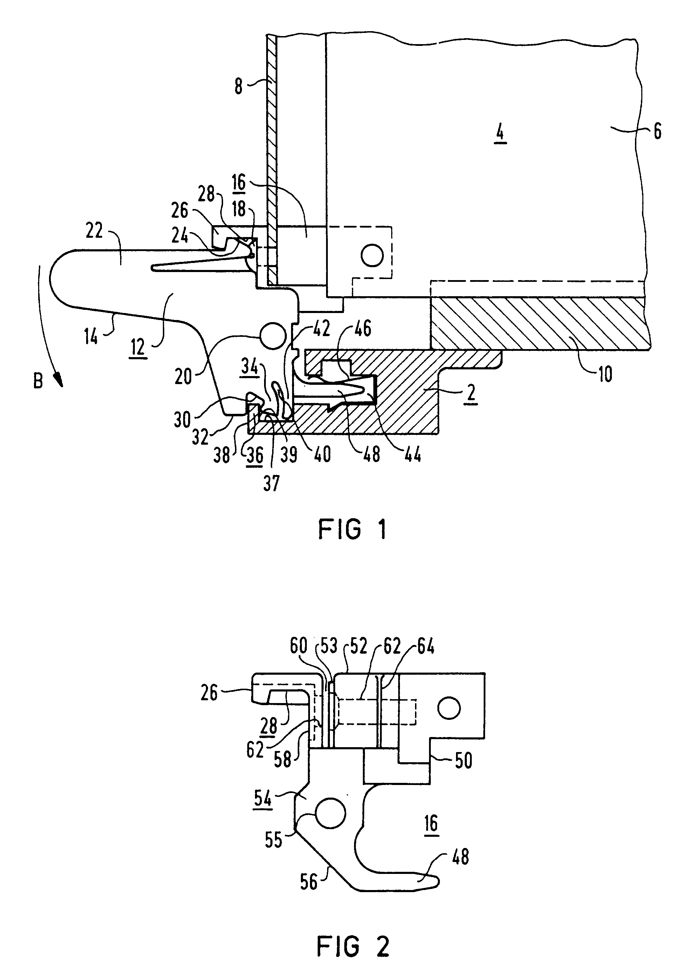

In der Darstellung nach FIG 1 ist abschnittsweise ein Baugruppenträger gezeigt, von dem der Übersichtlichkeit halber nur die untere Querschiene 2 dargestellt ist. Der Baugruppenträger dient zur Aufnahme von Steckbaugruppen 4, die jeweils aus einer mit Bauelementen und Kontaktelementen bestückten Leiterplatte 6 bestehen, die mit einer Frontplatte 8 zur Front des Baugruppenträgers hin versehen ist. Jede Steckbaugruppe 4 wird mittels Führungsschienen 10 im Baugruppenträger geführt. Bei einer Steckbaugruppe 4, beispielsweise mit doppeltem Europaformat, ist am oberen und unteren Ende jeder Frontplatte 8 jeweils eine Steck-und Ziehhilfe, von denen nur die Steck- und Ziehhilfe 12 dargestellt ist, angeordnet, wogegen bei einer Steckbaugruppe 4 im Europaformat nur eine Steck- und Ziehhilfe vorgesehen ist. Die der Übersichtlichkeit halber nicht dargestellte Steck- und Ziehhilfe am oberen Ende entspricht der dargestellten Steck- und Ziehhilfe 12, ist jedoch spiegelsymmetrisch angeordnet. Die Steck- und Ziehhilfe 12 besteht aus einem Hebel 14 und einem Endstück 16, das über eine Schraube 17 an der Leiterplatte 6 montiert ist. Außerdem ist das Endstück 16 über eine Preß-Verbindung und mittels einer Schraube 18 mit der Frontplatte form- und kraftschlüssig verbunden. Der Hebel 14, der mit seiner Drehachse 20 senkrecht zur Einschubrichtung in dem Endstück 16 gelagert ist, weist an seinen als Handhabe 22 ausgebildeten Hebel einen in sich selbst hemmenden, federnden Rasthaken 24 auf. Dieser Rasthaken 24 hintergreift in der Verriegelungsposition der Steck- und Ziehhilfe 12 eine korrespondierende Nase 26 einer der Querschiene 2 zugewandten Nut 28 des Endstücks 16. Dabei ist die Innenfläche der Nase 26 mit einer vorbestimmten Steigung in Richtung Nutgrund der Nut 28 versehen. Dementsprechend verläuft die korrespondierende Berührungsfläche des Rasthakens 24. Durch die Länge des Rasthakens 24 in Verbindung mit dem Material des Hebels 14 ist die Federkonstante festgelegt. Durch diese entsprechende Formgebung und Dimensionierung des Rasthakens 24 und der Nase 26 der Nut 28 des Endstücks 16 wird erreicht, daß die Steckbaugruppe 4 auch bei hoher mechanischer Beanspruchung sicher in seinen Steckverbindern gesteckt und verriegelt bleibt. Jedoch kann diese selbsthemmende Verriegelung durch die Bewegung des Hebels 14, gemäß dem Pfeil B, entriegelt werden, ohne dabei auf den Rasthaken 24 eine zusätzliche Kraft einwirken zu lassen.

Der Hebel 14 der Steck- und Ziehhilfe 12 ist mit einer Nut 30 versehen, deren außenliegende Kanten als Nasen 32 und 34 gestaltet sind. In der dargestellten Verriegelungsposition des Hebels 14 greift eine korrespondierende Nase 36 der Nut 37 der Querschiene 2 des Baugruppenträgers in die Nut 30 des Hebels 14 ein. Bei einer Schwenkbewegung des Hebels 14 in Richtung auf die Querschiene 2, gemäß dem Pfeil B, stützt sich die äußere Nase 32 der Nut 30 des Hebels 14 auf die Außenfläche 38 der korrespondierenden Nase 36 der Nut 37 der Querschiene 2 ab. Bei einer dieser Schwenkbewegung entgegengesetzten Bewegung, d.h. einer Bewegung des Hebels 14 in Richtung auf die Frontplatte 8, stützt sich die innere Nase 34 der Nut 30 des Hebels 14 auf die Innenfläche 39 der korrespondierenden Nase 36 der Nut 37 der Querschiene 2 ab. Außerdem ist die innere Nase 34 der Nut 30 derart mit einem Schlitz 40 versehen, daß der der Nut 30 des Hebels 14 abgewandte Teil der inneren Nase 34 einen federnden Schenkel 42 bildet. Bedingt durch die Elastizität des Materials des Hebels 14 und durch die Gestaltung des Schlitzes 40, wird die gesamte Nutbreite der Nut 37 der Querschiene 2 ausgefüllt, wodurch der Hebel 14 in der dargestellten Verriegelungsposition verspannt ist.

Ferner ist die Querschiene 2 des Baugruppenträgers mit einem Hohlraum 44 versehen, der durch einen nach vorn offen, liegenden U-Profil gebildet wird. In diesem Hohlraum 44 ist ein Kontaktmittel 46 über dessen gesamte Länge angeordnet. Als Kontaktmittel 46 ist eine Blattfeder mit kammartig ausgebildeten Federzungen vorgesehen. In der dargestellten Verriegelungsposition der Steck- und Ziehhilfe 12 kommt das Endstück 16 mittels eines zungenförmigen sich parallel zur Einschubrichtung erstreckenden Kontaktfläche 48 mit dem Kontaktmittel 46 der Querschiene 2 in großflächigen und demgemäß niederohmigen Kontakt.

In FIG 2 ist eine vorteilhafte Ausführungsform des Endstücks 16 dargestellt. Dieses Endstück 16 besteht aus einer zungenförmigen Kontaktfläche 48, einem Anschlag und Befestigungsteil 50 für eine Leiterplatte 6, einer Nut 28 und einer Befestigungsvorrichtung 52 für die Frontplatte 8. Die Kontaktfläche 48 ist mittels eines Verbindungsstücks 54 mit der Befestigungsvorrichtung 52 verbunden. Dieses Verbindungsstück 54 enthält beidseitig einen Zapfen 55 als Drehachse des Hebels 14 der Steck- und Ziehhilfe 12. Außerdem verjüngt sich das Verbindungsstück 54 zur zungenförmigen Kontaktfläche 48, wobei eine der Kontaktfläche 48 abgewandte Fläche 56 schräg verläuft. Die Fläche 56 dient als Abstützfläche des Hebels 14 in der Entriegelungsposition. In diese Entriegelungsposition wird der Hebel 14 mittels einer Feder, die am Endstück 16 angebracht ist, zwangsläufig gehalten. Dabei ist die Neigung dieser Fläche 56 so bestimmt, daß bei Einschieben einer mit dieser Steck- und Ziehhilfe 12 versehene Steckbaugruppe 4 in einem Baugruppenträger die äußere Nase 32 der Nut 30 des Hebels 14 dieser Steck- und Ziehhilfe 12 gegen die Außenfläche 38 der korrespndierenden Nase 36 der Nut 37 der Querschiene 2 kommt, so daß der Hebel 14 nur noch in Richtung der Frontplatte 8 bewegt werden muß, um die Steckbaugruppe 4 in die Endstellung zu stecken und zu verriegeln. Die der Nase 26 der Nut 28 gegenüberliegende Wand 58 und die Befestigungsvorrichtung 52 sind einander parallel mit einem vorbestimmten Abstand angeordnet, so daß ein Schlitz 60 gebildet wird. Die Befestigungsvorrichtung 52 ist mit einem Absatz 53 derart versehen, daß dieser Absatz 53 in den Schlitz 60 ragt und der Wand 58 gegenüber angeordnet ist. Die Breite des Absatzes 53 ist kleiner als die Breite des Schlitzes 60. Dadurch wird erreicht, daß die Tiefe des Schlitzes 60 stufenförmig abnimmt. Durch die stufenförmige Tiefe des Schlitzes 60 können U-förmige Frontplatten 8 und Frontplatten 8 aus Flachmaterial unterschiedlicher Dicke verwendet werden. Die Wand 58 und die Befestigungsvorrichtung 52 ist jeweils mit einer Gewindebohrung 62 versehen, die axial einander zugeordnet sind. Außerdem ist die Befestigungsvorrichtung 52 jeweils mit einem seitlich angebrachten Rasthaken 64 versehen. Dadurch können U-förmige Frontplatten 8, deren Breite gleich der Breite des Endstücks 16 ist, formschlüssig mit diesem Endstück 16 verbunden werden. U-förmige Frontplatten 8, deren Breite größer als die Breite des Endstücks 16 ist, werden zusätzlich mit dem Endstück 16 verschraubt, wodurch diese Frontplatten 8 form- und kraftschlüssig mit dem Endstück 16 verbunden sind. Es können auch Frontplatten 8 aus Flachmaterial verwendet werden, die ebenfalls mit dem Endstück 16 verschraubt werden. Durch die kraftschlüssige Verbindung wird außerdem die elektrische Kontaktierung der Frontplatte 8 zum Endstück 16 wesentlich verbessert.

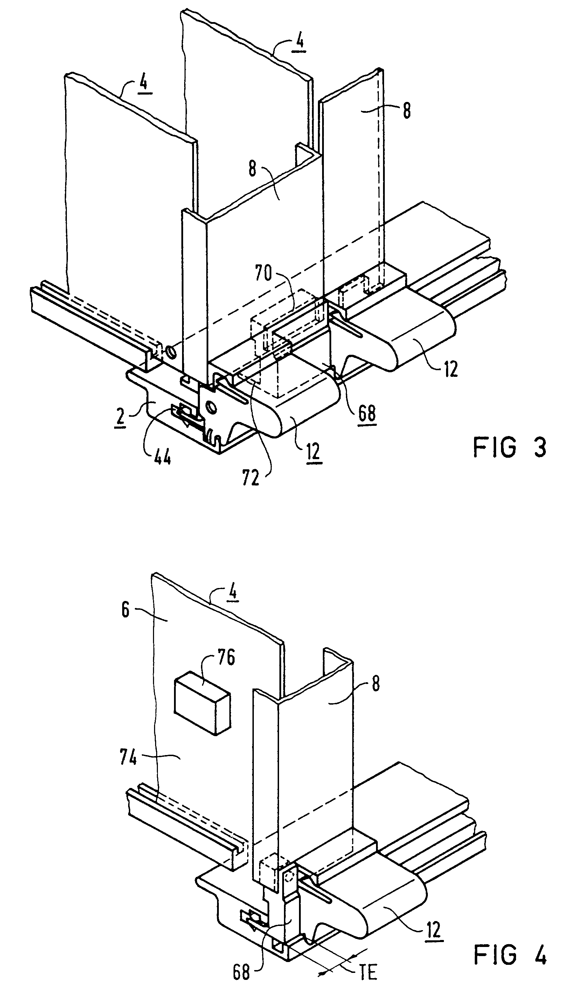

In FIG 3 sind zwei verschiedene Ausführungsformen des Frontsystems in einem Baugruppenträger dargestellt. Eine Steckbaugruppe 4 ist mit einer Frontplatte 8 aus Flachmaterial versehen, deren Breite gleichzeitig der Breite der Steck- und Ziehhilfe 12 ist. Die andere Steckbaugruppe 4 ist mit einer U-förmigen Frontplatte 8 versehen, deren Breite doppelt so groß ist wie die Breite der Steck- und Ziehhilfe 12. Die verbleibende Restbreite der U-förmigen Frontplatte 8 ist mit einer Abdeckung 68 versehen. Diese Abdeckung 68 kann form- und/oder kraftschlüssig mit der Frontplatte 8 verbunden sein. Dafür ist die Abdeckung 68 mit einem Schlitz 70 versehen, der senkrecht zur Einschubrichtung verläuft. Außerdem ist die Abdeckung 68 mit einer zungenförmigen in Einschubrichtung einer Steckbaugruppe 4 erstreckenden Fläche 72 versehen, wobei diese zungenförmige Fläche 72 bei eingesteckter Steckbaugruppe 4 in den Hohlraum 44 der Querschiene 2 des Baugruppenträgers ragt. Dementsprechend ist die Höhe der Abdeckung 68 gleich dem Abstand Hohlraum 44 - untere bzw. obere Kante der Frontplatte 8 plus die Tiefe des Schlitzes 70. Diese Abdeckung 68 kann als Spritzteil oder als Strangprofil am laufenden Meter gefertigt werden, wobei gemäß der abzudeckenden Restbreiten einer Frontplatte 8 vom laufenden Meter abgelängt werden kann.

In FIG 4 ist eine weitere Ausführungsform des Frontsystems mit einer Abdeckung 68 dargestellt. Die dargestellte Steckbaugruppe 4 hat zu den Bauteilen auf der Bauteileseite der Leiterplatte 6 auch noch Bauteile auf der Lötseite 74 der Leiterplatte 6, wobei der Übersichtlichkeit halber nur ein Surface Mounted Device (SMD)-Bauteil 76 dargestellt ist. Bedingt durch die Höhe des SMD-Bauteils wird im Baugruppenträger die nächste Rastlinie erreicht, wodurch die Breite der Frontplatte 8 um eine Teilungseinheit TE breiter ist als die Steck- und Ziehhilfe 12. Dadurch entsteht auch wieder eine Restbreite der Frontplatte 8 von der Breite einer Teilungseinheit TE. Auch hier ist diese Restbreite mit einer Abdeckung 68 versehen. Somit kann man mit einer standardmäßigen Steck- und Ziehhilfe 12 jede beliebig breite Frontplatte 8 zu einem Frontsystem verbinden, wobei die Restbreiten mit einer entsprechenden Abdeckung 68 versehen sind.

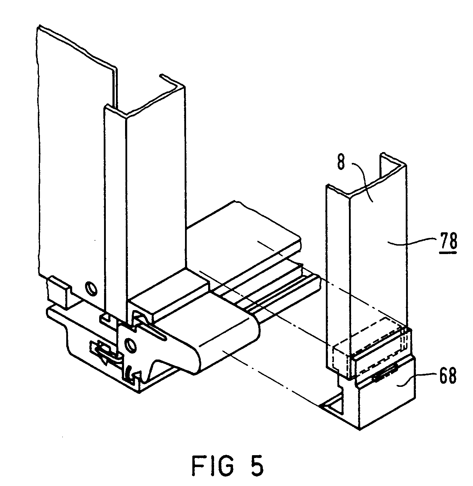

Die FIG 5 zeigt eine weitere Ausführungsform des Frontsystems, wobei neben einer Steckbaugruppe 4 eine Blindplatte 78 eingesteckt werden soll. Diese Blindplatte 78 besteht aus einer U-förmigen Frontplatte 8 und zweier Abdeckungen 68, wobei die obere Abdeckung 68 der Blindplatte 789 aus Übersichtlichkeitsgründen nicht dargestellt ist. Die Abdeckung 68 ist form- und/oder kraftschlüssig mit der Frontplatte 8 verbunden. Die Frontplatte 8 kann beliebig gewählt werden, vorzugsweise als Vielfaches einer Grundbreite, bezogen auf die Frontabmessungen des Baugruppenträgers, in welchem sie verwendet werden soll. Mit Hilfe der Blindplatte 78 wird der Teil des Baugruppenträgers abgedeckt, der nicht von Steckbaugruppen 4 besetzt ist. Es kann auch der Teil des Baugruppenträgers abgedeckt werden, der mit Steckbaugruppen ohne Frontplatte bestückt ist. Somit kann man mit Standardteilen jede beliebige verbleibende Fläche eines Baugruppenträgers abdecken.

## Patentansprüche

1. Frontsystem für eine in einen Baugruppenträger einschiebbare Steckbaugruppe (4) eines mechanischen Aufbausystemes, mit einer Steck- und Ziehhilfe (12), dessen mindestens einer Hebel (14) einen selbsthemmenden, federnden Rasthaken (24) aufweist und mittels eines Endstückes (16) derart mit der Steckbaugruppe (4) verbunden ist, daß die Drehachse (20) des Hebels (14) senkrecht zur Einschubebene in dem Endstück (16) gelagert ist, und mit einer Frontplatte (8), welche formschlüssig mit dem mindestens einen Endstück (16) verbunden ist, wobei
a) der Hebel (14) eine aus einer äußeren und inneren Nase (32, 34) bestehende Nut (30) aufweist, die in der Verriegelungsposition des Hebels (14) eine zur Nut (30) korrespondierende Nase (36) von einer Nut (37) in einer Querschiene (2) des Baugruppenträgers umgreift,
**dadurch gekennzeichnet,** daß
b) der Rasthaken (24) in der Verriegelungsposition des Hebels (14) eine über die Frontplatte (8) hinausstehende Nase (26) von einer der Querschiene (2) zugewandten Nut (28) des Endstückes (16) hintergreift.

2. Frontsystem nach Anspruch 1, **dadurch gekennzeichnet,** daß die innere Nase (34) der Nut (30) des Hebels (14) derart mit einem Schlitz (40) versehen ist, daß der der Nut (30) des Hebels (14) abgewandte Teil der inneren Nase (34) einen federnden Schenkel (42) bildet.

3. Frontsystem nach Anspruch 1, **dadurch gekennzeichnet,** daß das Endstück (16) mit einem senkrecht zur Einschubrichtung verlaufenden Schlitz (60) versehen ist, wobei in beiden diesen Schlitz (60) begrenzenden Wänden (58, 52) jeweils eine Gewindebohrung (62) vorgesehen ist, die axial in Einschubrichtung angeordnet sind.

4. Frontsystem mit einem in einen Hohlraum (44) der Querschiene (2) des Baugruppenträgers angeordneten Kontaktmittel (46) nach Anspruch 1, **dadurch gekennzeichnet,** daß das Endstück (16) mit einer zungenförmigen Kontaktfläche (48) versehen ist, die sich parallel zur Einschubrichtung der Steckbaugruppe (4) erstreckt und bei eingeschobener Steckbaugruppe (4) im Kontakt mit dem Kontaktmittel (46) der Querschiene (2) steht.

5. Frontsystem mit einer Frontplatte (8), deren Breite größer als die Breite einer Steck- und Ziehhilfe (12) ist, nach Anspruch 1, **dadurch gekennzeichnet,** daß ein verbleibendes vom Endstück (16) nicht besetzte Restbreite der Frontplatte (8) mit einer Abdeckung (68) versehen ist, wobei die Abdeckung (68) form- und/oder kraftschlüssig mit der Frontplatte (8) verbunden ist.

6. Frontsystem nach Anspruch 5, **dadurch gekennzeichnet,** daß die Abdeckung (68) mit einem senkrecht zur Einschubrichtung verlaufenden Schlitz (70) und mit einer zungenförmigen von der Frontseite der Abdeckung (68) in Einschubrichtung einer Steckbaugruppe (4) erstreckenden Fläche (72) versehen ist, wobei diese zungenförmige Fläche (72) bei eingeschobener Steckbaugruppe (4) in den Hohlraum (44) der Querschiene (2) des Baugruppenträgers steckt.

7. Frontsystem nach einem der Ansprüche 1, 5 oder 6, **dadurch gekennzeichnet,** daß Blindplatten (78), bestehend aus einer Frontplatte (8) und zweier Abdeckungen (68), zur Überbrückung der Front von nicht mit Steckbaugruppen (4) besetzten Teilen des Baugruppenträgers vorgesehen sind.

## Claims

1. Frontal system for a plug-in module (4) of a mechanical assembly system, which module can be plugged into a module carrier, having a plug-in and extraction aid (12), the at least one lever (14) of which has a self-locking, resilient stop hook (24) and is connected by means of an end piece (16) with the plug-in module (4) in such a way that the axis of rotation (20) of the lever (14) is mounted so as to be perpendicular to the plug-in plane in the end piece (16), and having a front plate (8) which is connected with the at least one end piece (16) in a form-locking manner, wherein
a) the lever (14) has a groove (30) which consists of an outer and an inner lug (32, 34) and which, in the locking position of the lever (14), embraces a lug (36), corresponding to the groove (30), of a groove (37) in a transverse rail (2) of the module carrier, characterised in that
b) the stop hook (24), in the locking position of the lever (14), engages behind a lug (26), projecting out over the front plate (8), of a groove (28) of the end piece (16) facing the transverse rail (2).

2. Frontal system according to claim 1, characterised in that the inner lug (34) of the groove (30) of the lever (14) is provided with a slot (40) in such a way that the portion of the inner lug (34) that is remote from the groove (30) of the lever (14) forms a resilient leg (42).

3. Frontal system according to claim 1, characterised in that the end piece (16) is provided with a slot (60) which extends so as to be perpendicular to the plug-in direction, with a threaded bore hole (62) being provided in the two walls (58, 52) which delimit this slot (60), which bore holes are arranged axially in the plug-in direction.

4. Frontal system having a contact means (46) arranged in a hollow space (44) of the transverse rail (2) of the module carrier according to claim 1, characterised in that the end piece (16) is provided with a tongue-shaped contact surface (48) which extends parallel to the plug-in direction of the plug-in module (4) and, when the plug-in module (4) is plugged in, is in contact with the contact means (46) of the transverse rail (2).

5. Frontal system having a front plate (8), the width of which is greater than the width of a plug-in and extraction aid (12), according to claim 1, characterised in that a remaining residual width of the front plate (8), which is not occupied by the end piece (16), is provided with a cover (68), with the cover (68) being connected with the front plate (8) in a form- and/or force-locking manner.

6. Frontal system according to claim 5, characterised in that the cover (68) is provided with a slot (70), which extends so as to be perpendicular to the plug-in direction, and with a tongue-shaped surface (72) which extends from the front side of the cover (68) in the plug-in direction of a plug-in module (4), wherein, when the plug-in module (4) is plugged in, this tongue-shaped surface (72) is plugged into the hollow space (44) of the transverse rail (2) of the module carrier.

7. Frontal system according to one of the claims 1, 5 or 6, characterized in that blanking plates (78) are provided, consisting of a front plate (8) and two covers (68), for bridging over the front of parts of the module carrier which are not occupied with plug-in modules (4).

## Revendications

1. Système frontal pour un module enfichable (4), pouvant être inséré dans un porte-modules, d'un système de construction mécanique, comportant un système auxiliaire d'enfichage et de tirage (12), dont au moins un levier (14) possède un crochet d'encliquetage élastique autobloquant (24) et est relié au module enfichable (4) au moyen d'un élément d'extrémité (16) de telle sorte que l'axe de rotation (20) du levier (14) est tourillonné perpendiculairement au plan d'insertion, dans l'élément d'extrémité (16), et à une plaque frontale (8), qui est reliée selon une liaison par formes complémentaires à ou aux éléments d'extrémité (16),
a) le levier (14) possédant une rainure (30) qui est constituée par un bec extérieur et un bec intérieur (32,34), et qui, lorsque le lever (14) est en position verrouillée, enserre un bec (36), qui correspond à la rainure (30), d'une rainure (37) ménagée dans un rail transversal (2) du porte-modules,
caractérisé par le fait que
b) lorsque le levier (14) est dans la position verrouillée, le crochet d'encliquetage (24) s'engage derrière un bec (26), qui fait saillie au-dessus de la plaque frontale (8), d'une rainure (28) de l'élément d'extrémité (16), tournée vers le rail transversal (2).

2. Système frontal suivant la revendication 1, caractérisé par le fait que les becs intérieurs (34) de la rainure (30) du levier (14) comportent une fente (40) de sorte que la partie, qui est tournée à l'opposé de la rainure (30) du levier (14), du bec intérieur (34) forme une branche élastique (42).

3. Système frontal suivant la revendication 1, caractérisé par le fait que l'élément d'extrémité (16) est pourvu d'une fente (60) qui est perpendiculaire à la direction d'insertion, et dans les deux parois (58,59) qui délimitent cette fente (60) sont prévus des perçages taraudés respectifs (62), qui sont disposés axialement dans la direction d'insertion.

4. Système frontal comportant un moyen de contact (46) disposé dans une cavité (44) des rails transversaux (2) du porte-modules, suivant la revendication 1, caractérisé par le fait que l'élément d'extrémité (16) est pourvu d'une surface de contact (48) en forme de languette, qui s'étend parallèlement à la direction d'insertion du module enfichable (4) et, lorsque le module enfichable (4) est à l'état inséré, est en contact avec le moyen de contact (46) des rails transversaux (2).

5. Système frontal comportant une plaque frontale (8), dont la largeur est supérieure à la largeur d'un système auxiliaire d'enfichage et de tirage (12), suivant la revendication 1, caractérisé par le fait qu'une largeur résiduelle, qui n'est pas occupée par l'élément d'extrémité (16), de la plaque frontale (8), est pourvue d'un revêtement (68) qui est relié, selon une liaison par formes complémentaires et/ou une liaison de force, à la plaque frontale (8).

6. Système frontal suivant la revendication 5, caractérisé par le fait que le revêtement (68) est pourvu d'une fente (70) qui s'étend perpendiculairement à la direction d'insertion, et une surface en forme de languette (72), qui s'étend depuis la face frontale du revêtement (68) dans la direction d'insertion d'un module enfichable (4), cette surface en forme de languette (72) étant enfichée dans la cavité (44) du rail transversal (2) du porte-modules lorsque le module enfichable (4) est à l'état inséré.

7. Système frontal suivant la revendication 1, 5 ou 6, caractérisé par le fait que des plaques de masquage (78) constituées par une plaque frontale (8) et deux revêtements (68) sont prévues pour combler, en le recouvrant, l'avant de parties du porte-modules, qui ne sont pas occupées par des modules enfichables (4).
